# EUROPÄISCHE PATENTSCHRIFT

(11) **EP 3 774 346 B1**
(45) Veröffentlichungstag und Bekanntmachung des Hinweises auf die Patenterteilung: **09.10.2024**
(21) Anmeldenummer: 19715860.3
(22) Anmeldetag: 28.03.2019
(51) Int. Cl.: B41F 35/00, B41F 15/08, B41F 15/26, H01L 21/677, H01L 31/18, H05K 3/12

(54) **DRUCKVORRICHTUNG**
PRINTING MACHINE
MACHINE D'IMPRESSION

(30) Priorität: 05.04.2018 DE 102018205157
(43) Veröffentlichungstag der Anmeldung: 17.02.2021
(73) Patentinhaber: Ekra Automatisierungssysteme GmbH, 74357 Bönnigheim (DE)
(72) Erfinder: REINISCH, Hubert, 71691 Freiberg am Neckar (DE)
(74) Vertreter: Clarenbach, Carl-Philipp
(86) Internationale Anmeldenummer: PCT/EP2019/057913
(87) Internationale Veröffentlichungsnummer: WO 2019/192926

(56) Entgegenhaltungen:
- EP-A2- 0 535 399
- WO-A1-2014/080010
- DE-A1- 102012 205 249

## Beschreibung

Die Erfindung betrifft eine Druckvorrichtung zum Bedrucken von Substraten wie beispielsweise Leiterplatten, Wafern oder Solarzellen, mit zumindest einem verschiebbar gelagerten Drucknest mit einer Arbeitsfläche, auf welcher die Substrate zum Bedrucken platzierbar sind, wobei dem Drucknest eine Transportbandeinrichtung zugeordnet ist, die eine Versorgungsrolle mit einem darauf aufgewickelten Transportband und eine Sammelrolle zum Aufrollen des Transportbands aufweist, sowie zwei der Auflagefläche zugeordnete Umlenkflächen, wobei das Transportband von der Versorgungsrolle über eine der Umlenkflächen auf die Arbeitsfläche zum Bilden einer Auflagefläche für die Substrate und von der Arbeitsfläche über die andere der Umlenkflächen zu der Sammelrolle geführt ist.

Druckeinrichtungen der eingangs genannten Art sind aus dem Stand der Technik bekannt. So offenbart beispielsweise die Offenlegungsschrift DE 600 02 775 T2 eine Druckvorrichtung mit einer Transportbandeinrichtung für ein Drucknest, mittels welchem Substrate einem Druckkopf zuführbar und von dem Druckkopf abführbar sind. Dazu erstreckt sich das Transportband über zwei Umlenkflächen unter dem Druckkopf hindurch. Dabei ist die Transportbandeinrichtung Teil des Drucknests, das eine Arbeitsfläche aufweist, über welchen das Transportband gezogen wird, um die Substrate auf der Arbeitsfläche zu positionieren und während des Bearbeitungsvorgangs zu stützen. Das Drucknest ist dabei verschiebbar ausgebildet, beispielsweise um die Substrate bezüglich des Druckkopfs auszurichten.

Aus der Offenlegungsschrift WO 2009/153160 A1 ist ein Drucknest für eine Druckvorrichtung bekannt, das eine Transportbandeinrichtung aufweist. Das Drucknest ist bewegbar an einem Drucktisch angeordnet und trägt sowohl die der Arbeitsfläche zugeordnete Umlenkfläche sowie eine Versorgungsrolle, von welcher das Transportband abgerollt wird, sowie eine Sammelrolle, auf welcher das Transportband aufgerollt wird. Der Vorteil des Transportbands liegt darin, dass das Substrat mittels des Transportbands selbst zu dem Druckkopf bewegbar und zu diesem ausrichtbar ist. Darüber hinaus handelt es sich in diesem Fall um ein Transportband, das nicht in einer Endlosschleife durch die Druckvorrichtung gespult wird, sodass bei einer Verschmutzung des Transportbands die Verschmutzung mit dem Transportband in die Sammelrolle abtransportiert und dadurch von der Druckvorrichtung entfernt wird. Dadurch wird eine Reinhaltung der Druckvorrichtung in einfacher Art und Weise gewährleistet. Insbesondere gilt dies, wenn das Transportband luftdurchlässig ausgebildet ist, sodass ein Substrat auf dem Drucknest durch Erzeugen eines Unterdrucks unterhalb der Arbeitsfläche durch die Arbeitsfläche und das Transportband hindurch das Substrat auf der Arbeitsfläche beziehungsweise der Auflagefläche des Transportbands angesaugt und arretiert wird, sodass der Druckvorgang sicher ohne zusätzliche Halteelemente durchführbar ist. Ähnliche Druckvorrichtungen gehen auch aus den Offenlegungsschriften EP 2 581 951 B1, US 2013/0052334 A1 und US 2012/0244702 A1 sowie EP 0 535 399 A2 hervor.

Aufgrund der Trägheit der offenbarten Drucknester ist die Arbeitsgeschwindigkeit der Druckvorrichtung begrenzt oder es muss mit einem hohen Materialaufwand das Gewicht des Drucknests reduziert werden, um dessen Trägheit zu verringern. Dies bringt jedoch einen entsprechenden Kostenmehraufwand mit sich, insbesondere wenn die Robustheit der Druckvorrichtung beibehalten werden soll. Insbesondere entsteht eine hohe bewegte Masse, wenn die Versorgungsrolle und/oder Sammelrolle mitbewegt werden müssen. Die Masse wird nochmals erhöht, wenn große Transportbandvorräte auf der Versorgungsrolle angestrebt werden, mit dem Ziel, geringe Wartungseingriffe zum Wechseln der Versorgungs- und Sammelrolle und den damit einhergehenden Stillstand der gesamten Produktionslinie zu gewährleisten.

Der Erfindung liegt daher die Aufgabe zugrunde, eine Druckvorrichtung zu schaffen, die ein Drucknest mit einer reduzierten Trägheit aufweist, ohne dass hierfür die Anforderungen an Material und Kosteneinsatz unwirtschaftlich werden.

Die der Erfindung zugrundeliegende Aufgabe wird durch eine Druckvorrichtung mit den Merkmalen des Anspruchs 1 gelöst. Diese hat den Vorteil, dass durch eine einfache Umordnung der Transportrollen der Transportbandeinrichtung die Trägheit des Drucknests reduziert wird. Dabei wird die Eigenschaft des Transportbands nutzbar gemacht, dass der Weg des Transportbands auch im Betrieb einfach und ohne großen Mehraufwand oder Mehrverschleiß veränderbar ist. Erfindungsgemäß ist vorgesehen, dass die Umlenkflächen an dem Drucknest mitverschiebbar und die drehbar gelagerte Sammelrolle sowie die drehbar gelagerte Versorgungsrolle ortsfest an der Druckvorrichtung gehalten sind. Bei den Umlenkflächen handelt es sich insbesondere um gekrümmte Oberflächen an dem Drucknest, über welche das Transportbandende gezogen wird, unter Anlage an den Umlenkflächen. Die Umlenkflächen gewährleisten einen geringen Verschleiß und insbesondere einen begrenzten minimalen Umlenkwinkel des Transportbands. Gemäß einer bevorzugten Ausführungsform wird die jeweilige Umlenkfläche von jeweils einer Umlenkrolle gebildet. Die Umlenkrollen sind drehbar an dem Drucknest gelagert, sodass der Verschleiß aufgrund von Reibung zwischen dem Transportband und der jeweiligen Umlenkfläche minimiert wird. Die Umlenkrollen erlauben somit ein einfaches Umlenken des Transportbands auf die Arbeitsfläche des Drucknests beziehungsweise von der Arbeitsfläche zu der Sammelrolle. Die Sammelrolle und die Versorgungsrolle sind aufgrund der Tatsache, dass sie selbst das Transportband lagern beziehungsweise zur Verfügung stellen und aufrollen, tragfähiger ausgebildet und weisen daher ein verhältnismäßig hohes Gewicht im Vergleich zu den Umlenkflächen oder Umlenkrollen auf. Durch das ortsfeste Anordnen der Sammelrolle und der Versorgungsrolle werden somit die Teile der Transportbandeinrichtung, welche zu einem erhöhten Gewicht des Drucknests führen, außerhalb des Drucknests, nämlich ortsfest an der Druckvorrichtung gehalten, sodass sie bei einem Verschieben des Drucknests nicht mitbewegt werden. Lediglich die dem Drucknest zugeordneten Umlenkflächen oder -rollen werden bewegt. Durch das Auslagern der verhältnismäßig schweren Sammelrolle und Versorgungsrolle und damit des "Transportbandlagers" wird somit die Trägheit des Drucknests erheblich reduziert. Wird das Drucknest verschoben, so verändert sich lediglich der Transportweg des Transportbands relativ zu Sammelrolle und Versorgungsrolle, was jedoch aufgrund der Verformbarkeit des Transportbands in Umlenkrichtung den Betrieb der Druckvorrichtung nicht beeinträchtigt. Somit ist es in einfacher Art und Weise möglich, die Trägheit des Drucknests zu reduzieren und dadurch eine erhöhte Arbeitsgeschwindigkeit der Druckvorrichtung, insbesondere eine erhöhte Geschwindigkeit beim Verschieben des Drucknests zu erreichen und dadurch den Durchsatz der Druckvorrichtung zu verbessern.

Gemäß einer bevorzugten Weiterbildung der Erfindung sind die Versorgungsrolle und die Sammelrolle unterhalb des Drucknests angeordnet. Dadurch wird das Transportband von unten über die eine Umlenkfläche auf die Arbeitsfläche und von der Arbeitsfläche über die andere Umlenkfläche wieder nach unten zu der Sammelrolle geführt. Dadurch ist es einfach möglich, eine Spannung auf das Transportband auszuüben, die sicherstellt, dass das Transportband stets flächig über die Auflagefläche verläuft und auf dieser aufliegt, sodass ein sicheres Transportieren und Positionieren des oder der Substrate auf der Arbeitsfläche gewährleistet ist. Darüber hinaus liegen dann Versorgungsrolle und Sammelrolle auf der von einem Druckkopf abgewandten Seite der Druckvorrichtung, sodass sie nicht zusätzlich Bauraum auf der Seite des Druckkopfs benötigen. Darüber hinaus wird dadurch gewährleistet, dass ein einfaches Zuführen und Abführen der Substrate von dem Transportband auf der Arbeitsfläche möglicht ist.

Erfindungsgemäß ist vorgesehen, dass die Druckvorrichtung einen Druckkopf aufweist, und dass das Drucknest zwischen einer dem Druckkopf zugeordneten Bearbeitungsposition und einer zumindest einer Zuführ- und/oder Abführeinrichtung für die Substrate zugeordneten Substrataustauschposition verschiebbar ist. Das Drucknest ist somit dem Druckkopf zuführbar, um dort einen Bearbeitungsvorgang, insbesondere Druckvorgang, durchzuführen, sowie der Zuführ- und/oder Abführeinrichtung, um zumindest ein Substrat aufzunehmen und/oder abzuführen. Durch die vorteilhafte Transportbandführung wird das Transportband mit dem Drucknest mitgeführt, ohne dass Sammelrolle und Versorgungsrolle mitbewegt werden. Durch das Verschieben des Drucknests ist somit ein schneller Austausch von Substraten für einen Bearbeitungsvorgang beziehungsweise Druckvorgang gewährleistet. Dadurch, dass das Drucknest zu einer Substrataustauschposition verschiebbar ist, besteht die Möglichkeit, in der Zeit, in welcher das Drucknest sich in der Substrataustauschposition befindet, ein anderes Drucknest dem Druckkopf zuzuführen, sodass gleichzeitig ein Druckvorgang sowie ein Substrataustauschvorgang durchführbar sind.

Gemäß einer bevorzugten Weiterbildung der Erfindung ist das Drucknest in der Ebene translatorisch verschiebbar. Dazu ist dem Drucknest insbesondere ein Aktuator zugeordnet, der das Drucknest elektromotorisch, elektromagnetisch, hydraulisch und/oder pneumatisch verschiebt. Insbesondere liegen zumindest die Bearbeitungsposition und die Substrataustauschposition in der gleichen Ebene. Alternativ liegen die Bearbeitungsposition und die Substrataustauschposition in unterschiedlichen Ebenen, wobei beispielsweise die Bearbeitungsposition höher liegt als die Substrataustauschposition, sodass im Bereich unterhalb eines Druckkopfs sehr geringe Absprünge einstellbar sind. Dabei ist es beispielsweise möglich, dass durch die Bewegung des Drucknests das zu bedruckende Substrat innerhalb eines Siebkleberands eines Drucksiebs des Druckkopfs positioniert wird. Zum Verschieben des Drucknests von der einen in die andere Position ist es denkbar, dass das Drucknest rein translatorisch verschoben wird oder unter Abweichung von der Ebene von der einen in die andere Position gehoben wird, beispielsweise entlang einer Kurvenbahn.

Gemäß einer bevorzugten Weiterbildung der Erfindung weist die Transportbandeinrichtung zwischen der Versorgungsrolle und/oder der Sammelrolle und zumindest einer der Umlenkflächen zumindest eine Spannvorrichtung auf, die auf das Transportband wirkt, um dieses zumindest in der Substrataustauschposition gespannt zu halten. Durch die Spannvorrichtung wird somit gewährleistet, dass das Transportband gespannt ist und sich dadurch nicht von den Rollen beziehungsweise Flächen im Betrieb löst, sodass gewährleistet ist, dass es insbesondere auf der Arbeitsfläche stets aufliegt und ein darauf befindliches Substrat sicher und präzise führt. Es wird dadurch erreicht, dass das Transportband stets einem vorbestimmten Weg folgt, sodass Beschädigungen und/oder Verletzungen sicher vermieden werden. Insbesondere ist die Spannvorrichtung derart ausgebildet, dass das Transportband während der zumindest im Wesentlichen horizontalen Bewegung des Drucknests entspannt oder nur leicht gespannt ist, um einen leichten Transport zu ermöglichen. Insbesondere nur in der Substrataustauschposition sorgt die Spannvorrichtung dafür, dass das Band gespannt ist, um ein sicheres Positionieren, Aufnehmen und Abführen der Substrate zu gewährleisten. Ist das Transportband nur locker gespannt, dann ist eine Verrutschgefahr zwischen dem Transportband und dem Substrat auf dem Drucknest relativ zueinander gering.

Gemäß einer bevorzugten Ausführungsform weist die Spannvorrichtung zumindest eine Spannrolle auf, die zwischen der Sammelrolle oder der Versorgungsrolle und der zumindest einen Umlenkfläche oder -rolle gegen das Transportband vorgespannt ist. Durch die Spannrolle wird somit eine zusätzliche Kraft auf das Transportband ausgeübt, durch welche das Transportband gespannt und an den Umlenkfläche oder -rolle und Sammelrolle und Versorgungsrolle gewährleistet wird.

Bevorzugt ist die jeweilige Spannrolle durch Federkraft gegen das Transportband vorgespannt, sodass ohne zusätzliche aktive Einwirkung eine dauerhafte Spannung des Transportbands automatisch gewährleistet ist. Insbesondere weist die Spannvorrichtung eine Spannrolle auf, die zwischen der Versorgungsrolle und der einen Umlenkfläche oder -rolle wirkt, und eine weitere Spannrolle, die zwischen der Sammelrolle und der anderen Umlenkfläche oder -rolle gegen das Transportband vorgespannt ist, auf. Dadurch ist ein sicherer Transport des Transportbands in jedem Fall, insbesondere wenn das Drucknest verschoben wird, gewährleistet.

Gemäß einer bevorzugten Weiterbildung weist die Transportbandeinrichtung zumindest eine verschiebbar gelagerte Umlenkfläche, insbesondere Umlenkrolle, auf, die mit dem Transportband zusammenwirkt, sowie einen ansteuerbaren Aktuator zum Verschieben der Umlenkfläche. Damit ist ein aktives Spannen oder Entspannen des Transportbands durch das Verschieben der verschiebbar gelagerten Umlenkfläche möglich. Dadurch wird beispielsweise erreicht, dass auch größere Bewegungswege des Drucknests durch eine Vergrößerung oder Verkleinerung des Transportbandwegs von der Versorgungsrolle zu der Arbeitsfläche oder von der Arbeitsfläche zu der Sammelrolle variierbar ist. Dadurch ist auch ein sicheres Nachführen und Aufrollen des Transportbands bei größeren Verschiebewegen der Drucknester sicher gewährleistet.

Vorzugsweise weist die Transportbandeinrichtung zwei erste Umlenkspannrollen zwischen der Versorgungsrolle und der einen Umlenkrolle und/oder zwei zweite Umlenkspannrollen zwischen der Sammelrolle und der anderen Umlenkrolle auf, jeweils im Bewegungsweg des Transportbands gesehen, wobei die verschiebbare Umlenkrolle der Transportbandspanneinrichtung insbesondere auf einer Höhe zwischen den ersten Umlenkspannrollen und/oder der zweiten Umlenkspannrolle insbesondere linear, insbesondere horizontal verschiebbar ist. Dabei können die Umlenkspannrollen und Umlenkrollen auch als nicht drehbare Umlenkspannflächen oder Umlenkflächen ausgebildet sein. Weil das Transportband auch mit der verschiebbaren Umlenkrolle zusammenwirkt, ergibt sich, dass das Transportband zwischen den beiden ersten oder zweiten Umlenkspannrollen durch die verschiebbare Umlenkrolle seitlich ausgezogen beziehungsweise ausgelenkt ist. Je nach Ausziehweite wird der Transportweg für das Transportband zwischen der Versorgungsrolle und der Arbeitsfläche oder zwischen der Arbeitsfläche und der Sammelrolle verkürzt oder verlängert. Dadurch ist ein aktives Nachführen beziehungsweise Nachziehen des Transportbands beim Verschieben des Drucknests möglich und erlaubt einen optimierten Betrieb der Druckvorrichtung. Besonders bevorzugt sind zwei verschiebbare Umlenkrollen vorhanden, wobei die eine Umlenkrolle der Versorgungsrolle und die andere Umlenkrolle der Sammelrolle zugeordnet ist und jeweils in der Höhe zwischen den ersten Umlenkspannrollen beziehungsweise den zweiten Umlenkspannrollen liegt. Bevorzugt sind die Umlenkrollen horizontal verlagerbar, jedoch ist auch eine andere Verlagerichtung denkbar. Bevorzugt sind die verschiebbaren Umlenkrollen an einem gemeinsamen Trägerelement befestigt, das insbesondere horizontal verschiebbar ist, und welchem der ansteuerbare Aktuator zum Verschieben der Umlenkrollen zugeordnet ist. Dadurch, dass die Umlenkrollen zwischen den ersten und zweiten Umlenkspannrollen verschiebbar sind, wird es erreicht, dass das Transportband über die Arbeitsfläche bewegt, ein Transportbandvorschub also ausgelöst wird, ohne dass sich dazu die Versorgungsrolle und Sammelrolle drehen müssen. Durch Verschieben des Trägerelements, das insbesondere als Schlitten ausgebildet ist, gibt die eine Umlenkrolle beim Verschieben Transportband frei und die andere Umlenkrolle nimmt das freiwerdende Transportband auf, beispielsweise wie bei einem Flaschenzug. Das hat zur Folge, dass das Transportband mit dem darauf liegenden Substrat bewegt beziehungsweise gefördert wird, obwohl die Versorgungsrolle und Sammelrolle stillstehen. Dadurch wird die bewegte träge Masse weiter reduziert und ein noch höherer Durchsatz der Druckvorrichtung ermöglicht. Dabei wird das Transportband nicht ausgetauscht, weil der Transportbandabschnitt, der zu Beginn auf der Arbeitsfläche aufliegt, nach dem Rückhub des Trägerelements wieder an seiner ursprünglichen Position auf der Arbeitsfläche zu liegen kommt. Dadurch wird ein schneller Vorschub und Rückschub des Transportbands für den im Maschinentakt zyklisch stattfindenden Substrataustausch gewährleistet. Für den Fall, dass das Transportband verschmutzt ist, werden die Versorgungsrolle und Sammelrolle angetrieben, damit frisches Transportband beziehungsweise bisher unbenutztes Transportband nachgefördert wird. In einem "normalen" Betrieb der Druckvorrichtung in einem Takt von beispielsweise 1000 µs, und wenn kein verschmutzter Transportbandabschnitt durch einen frischen Transportbandabschnitt ausgetauscht werden muss, drehen/bewegen sich die schweren Versorgungsrollen und Sammelrollen nicht, wodurch die bewegte Masse während des Arbeitsbetriebs besonders gering ist.

Gemäß einer bevorzugten Weiterbildung der Erfindung sind die Versorgungsrolle und die Sammelrolle zu den Umlenkflächen oder -rollen des Drucknests in der Bearbeitungsposition und in der Substrataustauschposition jeweils seitlich beziehungsweise vertikal versetzt angeordnet. Dabei wird auf die Drehachsen der Versorgungsrolle und der Sammelrolle sowie einer Mittelachse der Umlenkflächen des Drucknests in der Bearbeitungsposition und der Substrataustauschposition Bezug genommen. Die Achsen liegen vertikal nicht direkt übereinander, sondern sind versetzt zueinander. Hierdurch wird erreicht, dass das Transportband in der Bearbeitungsposition des Drucknests entspannt ist und in der Substrataustauschposition gespannt ist. Auf dem Weg zwischen Bearbeitungsposition und Substrataustauschposition ist das Transportband bevorzugt ebenfalls entspannt, sodass das Substrat auf dem Drucknest nicht verschoben wird und in der Substrataustauschposition ohne Zeitverzug förderbar ist. Insbesondere sind die Drehachsen um ein geringes Maß von einer Mittelachse der jeweiligen Drucknestumlenkung in der Bearbeitungsposition und der Substrataustauschposition beabstandet angeordnet. Gemäß einer ersten Ausführungsform liegt das Drucknest im Wesentlichen oberhalb der Versorgungsrolle in der Bearbeitungsposition und im Wesentlichen oberhalb der Sammelrolle in der Substrataustauschposition. Eine zweite Ausführungsform sieht eine umgekehrte Ausbildung vor.

Vorzugsweise weist die Transportbandeinrichtung eine Prüfeinrichtung zum berührungslosen Erfassen einer Transportbandverschmutzung auf. Die Prüfeinrichtung weist dazu beispielsweise einen Kamerasensor auf, welcher die Oberfläche des Transportbands, auf welche das jeweilige Substrat zur Bearbeitung abgelegt wird, erfasst und auf Verunreinigungen beziehungsweise auf Verschmutzung durch eine Bildauswertung überwacht. Wird beispielsweise erkannt, dass das Transportband nicht oder kaum verschmutzt ist, kann das Transportband zurückbewegt und erneut verwendet werden. Wird eine Verschmutzung erkannt, die insbesondere einen vorgebbaren Grenzwert überschreitet, wird das Transportband weiter auf die Sammelrolle aufgerollt und von der Versorgungsrolle abgerollt, sodass für den nächsten Bearbeitungsvorgang beziehungsweise für das nächste Substrat sauberes beziehungsweise unverschmutztes Transportband zur Verfügung steht.

Bevorzugt ist die Prüfeinrichtung derart an der Druckeinrichtung angeordnet, dass sie dem zwischen der anderen Umlenkrolle und der Sammelrolle verlaufenden Transportband in der Substrattauschposition des Drucknests gegenüberliegt. Die Prüfeinrichtung ist insoweit ortsfest an der Druckvorrichtung angeordnet. Anstatt die Prüfeinrichtung dem Transportband anzunähern, wird das Transportband an die Prüfeinrichtung angenähert, wenn das Drucknest in die Substrataustauschposition bewegt wird. Dadurch ist ein einfaches und sicheres Erfassen des Verschmutzungszugangs des Transportbands nach einem erfolgten Bearbeitungsvorgang beziehungsweise Druckvorgang gewährleistet.

Gemäß einer vorteilhaften Weiterbildung ist eine Reinigungseinrichtung zum Entfernen von Schutz von dem Transportband vorhanden. Die Reinigungseinrichtung ist beispielsweise als Absaugeinrichtung ausgebildet, die auf der Oberfläche des Transportbands befindlichen Schmutz von dem Transportband absaugt. Dadurch ist eine Mehrfachverwendung des Transportbands auch nach einer erfolgten Verschmutzung möglich.

Insbesondere ist die Reinigungseinrichtung derart an der Druckvorrichtung angeordnet, dass sie dem zwischen der anderen Umlenkfläche oder -rolle und der Sammelrolle verlaufenden Transportband in der Substrataustauschposition des Drucknests gegenüberliegt. Dadurch liegt die Reinigungseinrichtung dem Abschnitt des Transportbands gegenüber, welcher zuvor für einen Bearbeitungsvorgang genutzt wurde, und welcher aufgrund des Abführens des Substrats zur Abführ-/Zuführeinrichtung bereits von der Arbeitsfläche weg in Richtung der Sammelrolle transportiert wurde. Damit ist ein zusätzliches Bewegen des Transportbands nur zur Reinigungs- und Prüfzwecken nicht notwendig und es erfolgt ein besonders zeitsparender Prüfungs- und gegebenenfalls Reinigungsvorgang.

Vorzugsweise ist das Transportband als Papierband, Folienband oder Kunststoffvakuumband ausgebildet. Insbesondere das Papierband und das Kunststoffvakuumband haben den Vorteil, dass auf dem Transportband befindliche Substrate durch eine Vakuumerzeugung auf der von den Substraten abgewandten Seite des Transportbands einfach und sicher auf dem Transportband insbesondere für die Durchführung des Druckvorgangs arretierbar sind.

Besonders bevorzugt weist die Druckvorrichtung zwei verschiebbare Drucknester auf, die wie zuvor beschrieben ausgebildet sind und insoweit jeweils eine Transporteinrichtung aufweisen, wobei die Drucknester abwechselnd in die eine dem Druckkopf zugeordnete Bearbeitungsposition verschiebbar sind. Damit teilen sich die Drucknester denselben Druckkopf, beziehungsweise dem einen Druckkopf werden mehrere Drucknester abwechselnd zugeführt. Dadurch kann während der Bearbeitung eines Substrats beziehungsweise bei dem Bedrucken eines Substrats auf einem Drucknest ein Austauschvorgang durch das andere Drucknest vorgenommen werden. Dadurch sind die Stillstandszeiten der Druckvorrichtung besonders kurz und ein hoher Durchsatz der Druckvorrichtung ist gewährleistet.

Besonders bevorzugt ist jedem Drucknest eine eigene Zuführ- und Abführeinrichtung für die Substrate zugeordnet. Dadurch ist die gleichzeitige Bearbeitung und Zufuhr beziehungsweise Abfuhr der Substrate gewährleistet und der zuvor genannte hohe Durchsatz erreichbar.

Besonders bevorzugt weist die jeweilige Zuführ- und Abführeinrichtung ein Zuführförderband und ein Abführförderband auf, die übereinander liegen und in der Höhe verstellbar sind. Je nachdem, welches der beiden Förderbänder sich auf der Höhe des Drucknests, insbesondere der Arbeitsfläche des Drucknests in der Substrataustauschposition befindet, kann ein Substrat dem Drucknest zugeführt oder von dem Drucknest zu dem Abführförderband abgeführt werden. Hierdurch ist ein schneller Wechsel und ein schneller Austausch von Substraten auf dem jeweiligen Drucknest möglich, insbesondere während auf dem zumindest einen weiteren Drucknest ein Druckvorgang durchgeführt wird. Selbstverständlich können weniger oder auch mehr als nur zwei Drucknester vorhanden sein. So ist es beispielsweise denkbar, dass die Druckvorrichtung vier verschiebbare Drucknester, wie sie vorstehend beschrieben wurden, aufweist, die auf vier unterschiedlichen Seiten des Druckkopfs in einer gemeinsamen Ebene angeordnet und verschiebbar sind. Bevorzugt ist dabei jedem Drucknest eine eigene Zuführ- und Abführeinrichtung für Substrate zugeordnet.

Insbesondere sind das jeweilige Zuführband und Abführförderband an einem gemeinsamen, in der Höhe verstellbaren Halter angeordnet, sodass ein einfaches Zuführen und Abführen von Substraten mit nur wenigen Aktuatoren durchführbar ist.

Besonders bevorzugt ist dem jeweiligen Drucknest in seiner Substrataustauschposition zumindest ein Sensor, insbesondere Kamerasensor, einer Justiereinrichtung zum Erfassen und Korrigieren einer Position und/oder Ausrichtung zumindest eines auf dem Drucknest befindlichen Substrats zugeordnet. Dadurch ist es möglich, dass die Justiereinrichtung die Position und/oder Ausrichtung des jeweiligen Substrats insbesondere relativ zu dem Druckkopf korrigiert, um einen optimalen Druckvorgang durchzuführen. Dabei kann beispielsweise während der horizontalen Bewegung des Drucknests die Druckkopfausrichtung oder eine Korrektur der Ausrichtung des jeweiligen Drucknests durchgeführt werden.

Weitere Vorteile und bevorzugte Merkmale und Merkmalskombinationen ergeben sich aus dem zuvor Beschriebenen sowie aus den Ansprüchen. Im Folgenden soll die Erfindung anhand der Zeichnung näher erläutert werden. Dazu zeigen
- Figur 1: eine vereinfachte Draufsicht auf eine vorteilhafte Druckvorrichtung,
- Figur 2: eine vereinfachte Seitenansicht der Druckvorrichtung, und
- Figur 3: eine weitere Seitenansicht der Druckvorrichtung gemäß einem weiteren Ausführungsbeispiel.

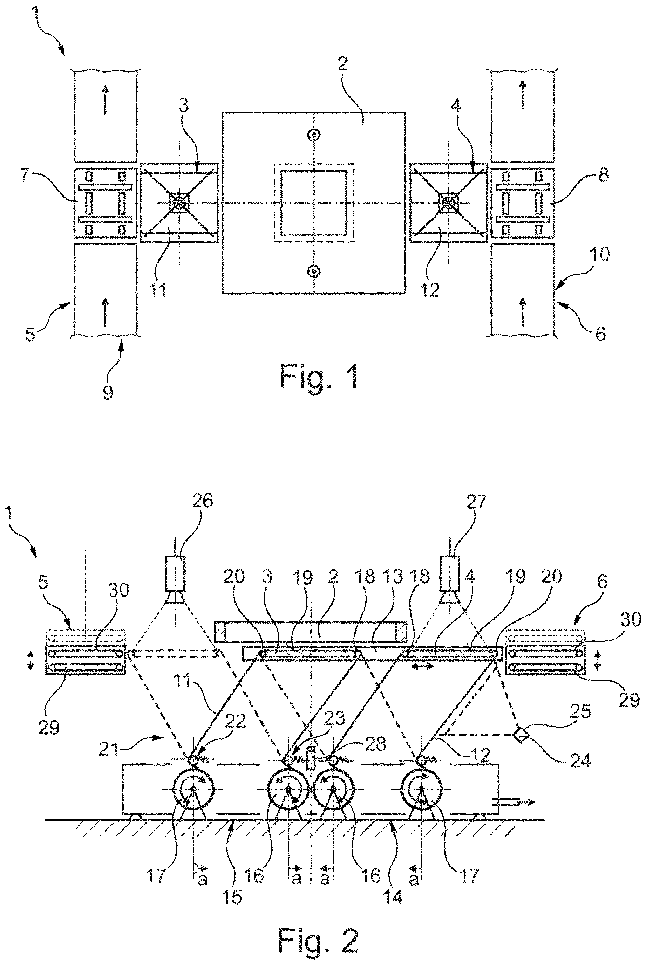

Figur 1 zeigt in einer vereinfachten Draufsicht eine vorteilhafte Druckvorrichtung 1, die einen Druckkopf 2 aufweist, der beispielsweise als Siebdruckeinrichtung ausgebildet ist. Dem Druckkopf 2 sind zwei Drucknester 3, 4 zugeordnet, die abwechselnd dem Druckkopf 2 zuführbar sind. Jedem Drucknest 3, 4 ist außerdem eine Zuführ- und Abführeinrichtung 5, 6 zugeordnet, die dazu dienen, zu bedruckende Substrate dem jeweiligen Drucknest 3, 4 zuzuführen und durch den Druckkopf 2 bedruckte Substrate von dem jeweiligen Drucknest 3, 4 wieder abzuführen. Gemäß dem vorliegenden Ausführungsbeispiel weist die jeweilige Zuführ- und Abführeinrichtung 5, 6 eine von einer Handhabungseinrichtung 7, 8 unterbrochene Förderbahn 9 beziehungsweise 10 auf, entlang welcher Substrate, wie durch Pfeile angezeigt, förderbar sind. Die Handhabungseinheit 7, 8 ist dazu ausgebildet, ein entlang der Förderbahn 9, 10 gefördertes Substrat auf das jeweils neben der Förderbahn 9, 10 liegende Drucknest 3, 4 zu fördern und damit dem Druckvorgang zur Verfügung zu stellen. Nach erfolgtem Druckvorgang wird das Substrat wieder zurück von dem Drucknest 3, 4 auf die jeweilige Handhabungseinheit 7, 8 gefördert und von dort entlang der Förderbahn weiter gefördert, beispielsweise zu einer Weiterverarbeitung oder Prüfung. Die Zufuhr und Abfuhr der Substrate auf beziehungsweise von der Handhabungseinheit 7, 8 kann auch von nur einer Bedienseite, beispielsweise in der Darstellung von Figur 1 nur von oben erfolgen. Insbesondere aus Gründen einer guten Zugänglichkeit von einer Seite, beispielsweise von der Maschinenrückseite, das heißt von der der Bedienseite abgewandten Seite der Druckvorrichtung, ist die Zufuhr und Abfuhr der Substrate von nur einer Bedienseite von Vorteil. So ist beispielsweise die Maschinenrückseite bei vorliegen nur einer Bedienseite für Wartungs- und/oder Einstellungszwecke stets zugänglich. Hierzu sind beispielsweise zwei nebeneinanderliegende oder übereinanderliegende und an der Druckvorrichtung vorbeiführende Förderbänder vorhanden, die jeweils ein Querband zur Zufuhr oder Abfuhr zu der Handhabungseinheit 7, 8 aufweisen, wobei die Querbänder des Förderbands, das auf der von der Druckvorrichtung abgewandten Seite des anderen Förderbands liegt, über oder unter dem dazwischenliegenden Förderband verlaufen.

Zur Förderung und Ausrichtung der Substrate auf dem jeweiligen Drucknest 3, 4 sind diese mit einem eigenen Transportband 11, 12 ausgestattet, das sich quer zur Förderrichtung der Förderbänder 9, 10 erstreckt und bewegbar ist.

Figur 2 zeigt hierzu eine vereinfachte Seitenansicht der Druckvorrichtung 1. Figur 2 zeigt dabei außerdem eine alternative Ausführungsform der Zuführ- und Abführeinrichtungen 5, 6, auf die weiter unten näher eingegangen werden soll.

Das jeweilige Drucknest 3, 4 ist horizontal zwischen einer dem Druckkopf 2 zugeordneten Bearbeitungsposition und einer der jeweiligen Zuführ- und Abführeinrichtung 5, 6 zugeordneten Substrataustauschposition horizontal verlagerbar. Gemäß dem Ausführungsbeispiel von Figur 2 befindet sich das Drucknest 3 in der Bearbeitungsposition und das Drucknest 4 in der Substrataustauschposition (jeweils durch durchgezogene Linien gezeichnet). In gestrichelten Linien sind das Drucknest 3 in der ihm zugeordneten Substrataustauschposition und das Drucknest 4 in der Bearbeitungsposition zusätzlich gezeichnet.

Die Drucknester 3, 4 sind an einem Rahmen 13 angeordnet, der zumindest im Wesentlichen horizontal bewegbar ist, um beide Drucknester 3, 4 gleichzeitig zu verschieben. Gemäß einem weiteren, hier nicht dargestellten Ausführungsbeispiel, sind die Drucknester 3, 4 unabhängig voneinander zumindest im Wesentlichen horizontal verschiebbar gelagert.

Wie zuvor bereits erwähnt, ist jedem der Drucknester 3, 4 ein Transportband 11 beziehungsweise 12 zugeordnet. Das jeweilige Transportband 11, 12 ist Bestandteil jeweils einer Transportbandeinrichtung 14, 15. Jede der Transportbandeinrichtungen 14, 15 weist eine Versorgungsrolle 16 auf, auf welcher das Transportband 11 beziehungsweise 12 gelagert ist. Die Rolle ist ortsfest an der Druckvorrichtung 1 drehbar gelagert. Weiterhin weist die jeweilige Transportbandeinrichtung 14, 15 eine Sammelrolle 17 auf, welche dazu dient, das von der Versorgungsrolle 16 abgerollte Transportband 11, 12 aufzurollen und zu sammeln. Es handelt sich somit nicht um einen Endlosriemen, sondern um ein endliches Transportband, das von der Versorgungsrolle 16 ab und von der Sammelrolle 17 aufgerollt wird. Wobei Versorgungsrolle 16 und Sammelrolle 17 auch umgekehrt betrieben werden können, sodass bereits aufgerolltes Transportband von der Sammelrolle 17 ab- und auf die Versorgungsrolle 16 aufgerollt wird, um beispielsweise ein Zurücktransportieren oder eine erneute Verwendung eines bereits verwendeten Abschnitts des Transportbands für einen Druckvorgang vorzusehen, wie durch Doppelpfeile an den Rollen 16, 17 gezeigt. Der Bewegungsweg des Transportbands verläuft dabei von der Transportrolle 16 über eine Umlenkrolle 18, die einer ersten Endkante einer Arbeitsfläche 19 des jeweiligen Drucknests 3 oder 4 liegt, über die Arbeitsfläche 3 hinweg bis zu einer weiteren Umlenkrolle 20, die auf der der Umlenkrolle 18 abgewandten Seite beziehungsweise Endkante der Arbeitsfläche 19 liegt, und von dort zu der Sammelrolle 17. Die Umlenkrollen 18, 20 sind drehbar gelagert und ihre Drehachsen sind parallel zueinander sowie parallel zu den Drehachsen der Versorgungsrolle 16 und der Sammelrolle 17 ausgerichtet, sodass ein verschleißarmer Transport des Transportbands 11 beziehungsweise 12 gewährleistet ist. Zwischen den ortsfesten Rollen 16, 17 und den mit dem jeweiligen Drucknest 3 mitbewegten Umlenkrollen 18, 20 ist weiterhin zu jedem Drucknest 3, 4 jeweils eine Spannvorrichtung 21 angeordnet, welche gewährleistet, dass das Transportband 11 beziehungsweise 12 zumindest in der Substrataustauschposition gespannt ist. Dazu weist gemäß dem vorliegenden Ausführungsbeispiel die Spannvorrichtung 21 eine erste federvorgespannte Spannrolle 22 auf, die in Förderrichtung der Versorgungsrolle 16 nach und der Umlenkrolle 18 vorgeschaltet ist, sowie eine zweite federvorgespannte Spannrolle 23, die der Umlenkrolle 20 nach und der Sammelrolle 17 vorgeschaltet ist. Beide Spannrollen 20, 23 werden durch Federkraft derart vorgespannt, dass sie das Transportband 11 seitlich auslenken, sodass dieses nicht den kürzesten Weg von der Spannrolle 16 zu der Umlenkrolle 18 beziehungsweise von der Umlenkrolle 20 zu der Sammelrolle 23 folgt, sondern einem durch die Auslenkung der jeweilige Spannrolle 22, 23 verlängerten Weg.

Weiterhin sind die Drehachsen der Versorgungsrolle 16 und der Sammelrolle 17 derart bezogen auf das jeweilige Drucknest 3, 4 und die Bearbeitungsposition sowie die Substrataustauschposition angeordnet, dass die Drehachsen um einen Weg a versetzt zu einer Mittelachse des Drucknests 3 beziehungsweise 4 in der Bearbeitungsposition sowie in der Substrataustauschposition liegen. Bezogen auf das Drucknest 3 liegt somit die Drehachse der Sammelrolle 17 außermittig zu der Mittelachse des Drucknests 3 in der Substrataustauschposition (gestrichelt gezeichnet) und Bearbeitungsposition und die Versorgungsrolle 16 versetzt zu der Mittelachse des Drucknests 3 zwischen der Bearbeitungsposition und der Substrataustauschposition, bezogen auf die jeweilige Umlenkung am Drucknest 3. Für das Drucknest 4 gilt entsprechend, dass die Versorgungsrolle 16 sich zwar unterhalb des Drucknests 4 in der Bearbeitungsposition befindet, jedoch mit seiner Drehachse versetzt zur Mittelachse der beiden Positionen der Umlenkrolle 19 des Drucknests 4 des Drucknests 4, und die Sammelrolle 17 entsprechend unterhalb des Drucknests 4 in der Substrataustauschposition (durchgezogene Linien), jedoch mit seiner Drehachse jeweils versetzt zur Mittelachse der beiden Positionen der Umlenkrolle 20 des Drucknests 4.

Dadurch, dass die Versorgungsrollen 16 sich im Bereich des Druckkopfs 2 befinden, ist gewährleistet, dass beim Abrollen der Versorgungsrolle das Transportband nach außen in Richtung der jeweiligen Zuführ- und Abführeinrichtung 5, 6 bewegt wird, sodass durch das Transportieren des jeweiligen Substrats von dem jeweiligen Drucknest 3, 4 in Richtung der Zuführ- und Abführeinrichtung 5, 6 automatisch das Transportband 11 weiter gefördert und von der Versorgungsrolle 16 ab und von der Sammelrolle 17 aufgerollt wird, sodass für den nächsten Bearbeitungsvorgang wieder neues Transportband 11 auf der Arbeitsfläche 19 aufliegt, während gegebenenfalls verschmutztes Transportband weitergefördert wurde.

Im Normalbetrieb wird nunmehr auf dem Drucknest 4 zunächst ein Substrat durch die Zuführ- und Abführeinrichtung 6 und die Bewegung des Transportbands 12 positioniert. Anschließend wird der Rahmen 13 in Richtung der Zuführ- und Abführeinrichtung 5 zumindest im Wesentlichen horizontal verschoben, wodurch das Drucknest 3 in die Substrataustauschposition und das Drucknest 4 in die Bearbeitungsposition unterhalb des Druckkopfs 2 gelangen. Während nun mittels des Druckkopfs ein Druckvorgang auf dem Substrat, das auf dem Drucknest 4 liegt, durchgeführt wird, insbesondere mittels Siebdruck oder Schablonendruck, wird durch die Zuführ- und Abführeinrichtung 5 ein Substrat auf das Drucknest 3 befördert, gegebenenfalls unter Zuhilfenahme der Bewegung des Transportbands 11. Ist der Druckvorgang auf dem Drucknest 4 beendet, wird der Rahmen 13 zurück in die vorhergehende Position verschoben, wodurch das Drucknest 4 in seine Substrataustauschposition und das Drucknest 3 in die Bearbeitungsposition unterhalb des Druckkopfs 2 gelangt. Nunmehr wird durch den Druckkopf 2 das auf dem Drucknest 3 befindliche Substrat bedruckt, während das bedruckte Substrat auf dem Drucknest 4 von diesem in Richtung der Zuführ- und Abführeinrichtung 6 gefördert wird. Dazu wird das Transportband 12 auf die Sammelrolle 17 aufgerollt, wodurch das Substrat in Richtung der Zuführ- und Abführeinrichtung 6 gefördert wird. Das jeweilige Transportband 11, 12 ist insbesondere luftdurchlässig ausgebildet, sodass im Bereich der Druckvorrichtung 2 durch eine Vakuumeinrichtung ein Unterdruck erzeugbar ist, durch welchen auf dem Transportband 12 im Bereich der Arbeitsfläche 19 befindliche Substrate gegen das Drucknest 3 oder 4 gesaugt und dadurch für den Druckvorgang arretiert werden.

Das an dem Druckvorgang beteiligte Transportband 12 beziehungsweise der Abschnitt, der während des Druckvorgangs auf der Arbeitsfläche 19 aufliegt, wird nunmehr über die Umlenkrolle 20 des Drucknests 4 in Richtung der Sammelrolle 17 bewegt. Der Abstand zwischen der Umlenkrolle 20 und der Sammelrolle 17 ist dabei optional derart gewählt, dass er mindestens so groß ist, wie der Abstand zwischen den Umlenkrollen 18 und 20, sodass der während des Druckvorgangs verwendete Abschnitt vollständig in dem Bereich zwischen der Umlenkrolle 20 und der zweiten Spannrolle 23 liegt. Diesem Abschnitt ist optional eine Prüfeinrichtung 24 zugeordnet, die insbesondere einen Kamerasensor 25 aufweist, mittels dessen der Verschmutzungsgrad der Oberfläche des Transportbands 11 erfassbar ist. In der Substrataustauschposition liegt damit das Transportband der Prüfeinrichtung 24 gegenüber. Eine entsprechende Prüfeinrichtung 24 ist bevorzugt auch auf der Seite des Drucknests 3 angeordnet und wirkt mit dem Transportband 11 entsprechend zusammen, um dessen Verschmutzung nach einem durchgeführten Druckvorgang zu prüfen. Weil durch den Abtransport des Substrats von dem Drucknest 4 auf die Zuführ- und Abführeinrichtung 6 bereits das Transportband 12 in Richtung der Sammelrolle 17 und damit in dem Erfassungsbereich der Prüfeinrichtung 24 bewegt wurde, ist ein erneutes Bewegen des Transportbands nur für die Prüfung des Verschmutzungsgrads nicht notwendig.

Wird erkannt, dass der Verschmutzungsgrad gering ist, so wird das Transportband 12 bevorzugt zurück auf die Arbeitsfläche 19 des Drucknests 4 zusammen mit der Zuführung des nächsten Substrats gefördert, um einem erneuten Druckvorgang zur Verfügung zu stehen. Dadurch wird ein vorzeitiger Verbrauch des Transportbands 12 vermieden. Wird jedoch durch die Prüfeinrichtung 24 erkannt, dass das Transportband 12 eine Verschmutzung aufweist, die über einen vorgegebenen Grenzwert hinausgeht, so wird das Transportband 12 derart weit transportiert, dass ein frischer, noch unbenutzter Abschnitt des Transportbands 12 zur Aufnahme eines weiteren Substrats zur Verfügung steht. Entsprechend wird mit dem Transportband 11 vorgegangen.

Zur Optimierung des Druckvorgangs ist der jeweiligen Substrataustauschposition des Drucknests 4 und des Drucknests 3 jeweils eine Kameraeinrichtung 26, 27 zugeordnet, die Teil einer Justiervorrichtung ist, mittels welcher das oder gegebenenfalls mehrere auf dem jeweiligen Drucknest 3, 4 abgelegte Substrate in Bezug auf ihre Ausrichtung und Anordnung erfasst und mittels der Justiervorrichtung in ihrer Ausrichtung und Position relativ zumindest Druckkopf 2 und Drucknester 3, 4 gegebenenfalls korrigiert werden, um einen optimalen Druckvorgang durch den Druckkopf 2 durchführen zu können. Zum Korrigieren der Ausrichtung und/oder Position werden bevorzugt der Druckkopf 2 und/oder das jeweilige Drucknest 3, 4 verstellt, insbesondere in Abhängigkeit der von der Kameraeinrichtung 26, 27 zur Verfügung gestellten Signale.

Dadurch, dass die Versorgungsrollen 16 und die Sammelrollen 17 ortsfest an der Druckvorrichtung 1 angeordnet sind, weisen die Drucknester 3, 4 ein besonders geringes Gewicht und damit eine besonders geringe Trägheit auf, die eine schnelle Verschiebung der Drucknester 3, 4 ermöglicht. Dadurch ist ein hoher Durchsatz an Substraten mittels der Druckvorrichtung 1 gewährleistet.

Vorzugsweise ist außerdem der Bearbeitungsposition der Drucknester 3, 4 eine weitere Kameraeinrichtung 28 zugeordnet, die die korrekte Positionierung der Drucknester 3, 4 unterhalb des Druckkopfs 2 überwacht.

Während gemäß dem Ausführungsbeispiel von Figur 1 die Substrate von der jeweiligen Förderbahn 9, 10 mittels der Handhabungseinheit 7, 8 zu- oder abgeführt werden, ist gemäß dem Ausführungsbeispiel von Figur 2 vorgesehen, dass die jeweilige Zuführ- und Abführeinrichtung 5, 6 zweistöckig ausgebildet ist, und jeweils ein erstes Förderband 29 zum Zuführen von Substraten und ein darüber liegendes zweites Förderband 30 zum Abführen von Substraten aufweist. Die Förderbänder 29, 30 sind dabei in der Höhe verstellbar, wie durch einen Doppelpfeil in Figur 2 angedeutet, um entweder das zuführende Förderband 29 zur Übergabe eines Substrats an das jeweilige Drucknest 3, 4 in der Substrataustauschposition zu ermöglichen, oder die Förderbänder 29, 30 sind nach unten verschoben, sodass das Förderband 30 zum Abfördern eines Substrats auf Höhe des Drucknests 3 oder 4 liegt, sodass ein einfaches Verschieben des Substrats von dem Drucknest 3 auf das Förderband 30 zum Abtransport gewährleistet ist.

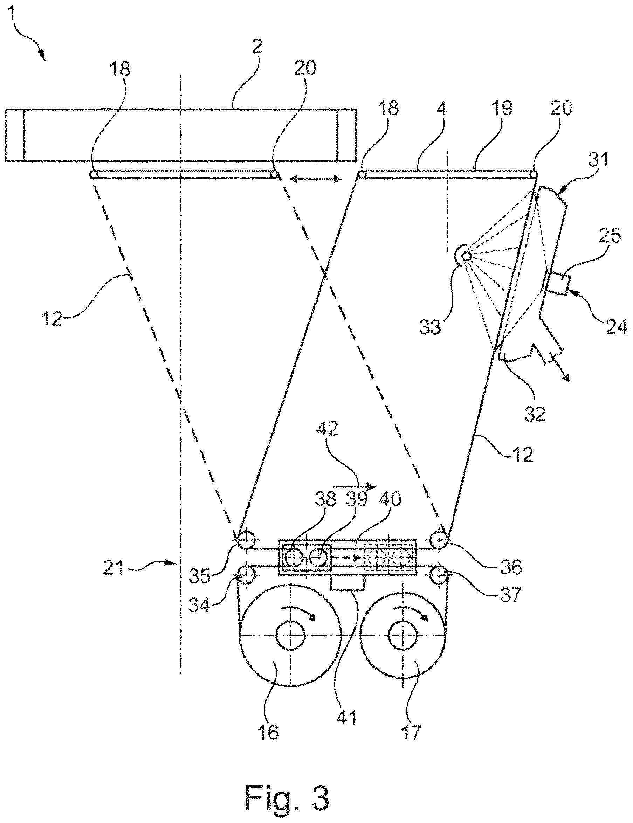

Figur 3 zeigt ein weiteres Ausführungsbeispiel der Druckeinrichtung 1, wobei in diesem Ausführungsbeispiel nur das Drucknest 4 gezeigt ist, das Drucknest 3 ist bevorzugt dazu korrespondierend ausgebildet. Selbstverständlich kann die Druckvorrichtung 1 aber auch nur eines der beiden Drucknester 3 oder 4 aufweisen. Ebenso ist es möglich, dass die Druckvorrichtung 1 mehr als zwei Drucknester 3, 4 aufweist, die dann insbesondere unabhängig voneinander verschiebbar sind.

Das Ausführungsbeispiel von Figur 3 unterscheidet sich von dem Ausführungsbeispiel von Figur 2 dadurch, dass zusätzlich zu der Prüfeinrichtung 24 mit dem Kamerasensor 25 eine Reinigungseinrichtung 31 vorhanden ist. Die Reinigungseinrichtung 31 weist insbesondere eine Absaugung 32 auf, die das Transportband 12 in der Substrataustauschposition des Drucknests 4 zumindest bereichsweise überdeckt, um durch einen Unterdruck Schmutzpartikel oder Druckreste von der Oberfläche des Transportbands 12 abzusaugen und zu entfernen, sodass dieser Abschnitt des Transportbands 12 für einen weiteren Druckvorgang nutzbar gemacht ist. Optional wird das Transportband 12 von der Rückseite her mittels einer Druckluftvorrichtung 33 beaufschlagt, um das Lösen der Schmutz- oder Druckreste von dem Transportband 12 zu vereinfachen. Optional ist dem Transportband außerdem eine Lichtquelle zugeordnet, die das Transportband 12 seitlich anstrahlt, um die Verschmutzungsprüfung mittels Gegenlicht zu unterstützen.

Das Ausführungsbeispiel von Figur 3 unterscheidet sich durch ein weiteres Merkmal von dem vorhergehenden Ausführungsbeispiel, das unabhängig von der Reinigungsvorrichtung 31 vorhanden sein kann. Dabei handelt es sich um eine spezielle Ausbildung der Spannvorrichtung 21. In diesem Fall wird die Spannvorrichtung 21 durch vier feststehende Umlenkspannrollen 34, 35, 36 und 37 gebildet und zwei verlagerbaren Umlenkrollen 38 und 39.

Durch die Umlenkspannrollen 34, 38 und 35 wird das Transportband 12 auf dem Weg von der Versorgungsrolle 16 zu der Umlenkrolle 18 seitlich ausgelenkt, und durch die Umlenkrollen 36, 37 und 39 das Transportband 12 auf dem Weg von der Umlenkrolle 20 zu der Sammelrolle 17.

Dazu liegen die Umlenkrollen 34 und 35 sowie die Umlenkrollen 36 und 37 jeweils beabstandet zueinander ortsfest oder für eine Spann-, und Führungswirkung des Transportbands 12 übereinander. Die jeweilige Umlenkrolle 38 beziehungsweise 39 liegt dabei auf der Höhe zwischen den Umlenkrollen 34, 35 und 36, 37, sodass das Transportband durch die Umlenkrollen 38, 39 seitlich ausgelenkt ist, wodurch der Transportweg des Transportbands 12 durch die Umlenkrolle 39, 38 verlängert ist. Die Umlenkrollen 38, 39 sind an einem gemeinsamen Trägerelement 40, insbesondere Schlitten, drehbar gelagert, das durch ein Aktuator 41 horizontal verschiebbar ist. Durch das Verschieben wird der Weg des Transportbands 12 von der Versorgungsrolle 16 zu der Umlenkrolle 18 verlängert und gleichzeitig der von der Umlenkrolle 20 zu der Sammelrolle 17 verkürzt, gemäß Pfeil 42. Dadurch ist ein aktives Beeinflussen der Transportbandspannung und insbesondere der Transportbandabschnitte zwischen Versorgungsrolle 16 und Umlenkrolle 18 beziehungsweise Umlenkrolle 20 und Sammelrolle 17 erreichbar, durch welche erreicht wird, dass zum Transportieren des Transportbands 12 entlang der Arbeitsfläche 19 des Drucknests 4 die Versorgungsrolle 16 und die Sammelrolle 17 nicht angetrieben werden müssen und vielmehr stillstehen können. Allein durch das Bewegen des Schlittens beziehungsweise des Trägerelements 40 wird das Transportband 12 über die Arbeitsfläche bewegt und dadurch ein Substrat beispielsweise der Zuführ- und Abführeinrichtung 6 zugeführt oder von dieser aufgenommen.

Die mit Bezug auf Figur 3 beschriebenen Optionen für das Drucknest 4 sind vorzugsweise ebenfalls für das Drucknest 3 oder jedes weitere Drucknest der Druckvorrichtung 1 und damit für das jeweils zugehörige Transportband 11 beziehungsweise die zugehörige Transportbandeinrichtung 15 vorgesehen.

Während in den vorliegenden Ausführungsbeispielen die Umlenkrollen 18, 20, 22, 23, 34 - 39 stets als drehbar gelagerte Rollen ausgeführt sind, ist gemäß einem weiteren Ausführungsbeispiel, hier nicht dargestellt, vorgesehen, dass anstelle der beweglichen Umlenkrollen feststehende Umlenkflächen beispielsweise an dem jeweiligen Drucknest 3, 4 ausgebildet sind, deren Krümmung beispielsweise der Krümmung der Rollen entspricht. Durch das Vorsehen von Umlenkflächen anstelle von Umlenkrollen wird das Gewicht der Drucknester 3, 4 weiter reduziert.

## Patentansprüche

1. Druckvorrichtung (1) zum Bedrucken von Substraten, wie beispielsweise Leiterplatten, Wafern oder Solarzellen, mit zumindest einem verschiebbar gelagerten Drucknest (3,4) mit einer Arbeitsfläche (19), auf welcher die Substrate zum Bedrucken platzierbar sind, wobei dem Drucknest (3,4) eine Transportbandeinrichtung (15,14) zugeordnet ist, die eine drehbar gelagerte Versorgungsrolle (16) mit einem darauf aufgewickelten Transportband (11,12) und eine drehbar gelagerte Sammelrolle (17) zum Aufrollen des Transportbands (11,12) aufweist, sowie zwei der Arbeitsfläche (19) zugeordnete Umlenkflächen, insbesondere Umlenkrollen (18,20), wobei das Transportband (11,12) von der Versorgungsrolle (16) über eine der Umlenkflächen auf die Arbeitsfläche (19) zum Bilden einer Auflagefläche für die Substrate und von der Arbeitsfläche (19) über die andere der Umlenkflächen zu der Sammelrolle (17) geführt ist, und mit einem Druckkopf (2), wobei das Drucknest (3,4) zwischen einer dem Druckkopf (2) zugeordneten Bearbeitungsposition und einer einer Zuführ- oder Abführeinrichtung (5,6) für die Substrate zugeordneten Substrataustauschposition verschiebbar ist, wobei die Umlenkflächen (18,20) an dem jeweiligen Drucknest (3,4) mitverschiebbar gehalten sind, **dadurch gekennzeichnet, dass** sowohl die Versorgungsrolle (16) als auch die Sammelrolle (17) ortsfest an der Druckvorrichtung (1) gehalten sind.

2. Druckvorrichtung nach Anspruch 1, **dadurch gekennzeichnet, dass** die Versorgungsrolle (16) und die Sammelrolle (17) unterhalb des Drucknests (3,4) angeordnet sind.

3. Druckvorrichtung nach einem der vorhergehenden Ansprüche, **dadurch gekennzeichnet, dass** das Drucknest (3,4) zumindest im Wesentlichen in einer horizontalen Ebene verschiebbar ist.

4. Druckvorrichtung nach einem der vorhergehenden Ansprüche, **dadurch gekennzeichnet, dass** die Transportbandeinrichtung (15,14) zwischen der Versorgungsrolle (16) und/oder der Sammelrolle (17) und zumindest einer der Umlenkrollen (18,20) zumindest eine Spannvorrichtung (21) aufweist, die auf das Transportband (11,12) wirkt, um dieses zumindest in der Substrataustauschposition gespannt zu halten.

5. Druckvorrichtung nach Anspruch 4, **dadurch gekennzeichnet, dass** die Spannvorrichtung (21) zumindest eine Spannrolle (22,23) aufweist, die zwischen der Sammelrolle (17) oder der Versorgungsrolle (16) und der zumindest einen Umlenkrolle (18,20) gegen das Transportband (11,12) vorgespannt ist.

6. Druckvorrichtung nach einem der vorhergehenden Ansprüche, **dadurch gekennzeichnet, dass** die Transportbandeinrichtung (15,14) zumindest eine verschiebbar gelagerte Umlenkrolle (38,39) aufweist, die mit dem Transportband (11,12) zusammenwirkt, sowie einen ansteuerbaren Aktuator (41) zum Verschieben der verschiebbar gelagerten Umlenkrolle (38,39).

7. Druckvorrichtung nach Anspruch 6, **dadurch gekennzeichnet, dass** die Transportbandeinrichtung (15,14) zwei erste Umlenkspannkrollen (34,35) zwischen der Versorgungsrolle (16) und der einen Umlenkrolle (18) und/oder zwei zweite Umlenkspannrollen (36,37) zwischen der Umlenkrolle (20) und der Sammelrolle (17) aufweist, wobei die verschiebbar gelagerten Umlenkrollen (38,39) zwischen den ersten Umlenkspannrollen (34,35) und/oder der zweiten Umlenkspannkrollen (36,37) insbesondere linear verschiebbar ist.

8. Druckvorrichtung nach einem der vorhergehenden Ansprüche, **dadurch gekennzeichnet, dass** die Versorgungsrolle (16) und die Sammelrolle (17) zu den Umlenkflächen des Drucknests (3,4) in der Bearbeitungsposition und in der Substrataustauschposition jeweils vertikal versetzt angeordnet sind.

9. Druckvorrichtung nach einem der vorhergehenden Ansprüche, **dadurch gekennzeichnet, dass** die Transportbandeinrichtung (15,14) eine Prüfeinrichtung (24) zum berührungslosen Erfassen einer Transportbandverschmutzung aufweist.

10. Druckvorrichtung nach einem der vorhergehenden Ansprüche, **dadurch gekennzeichnet, dass** eine Reinigungseinrichtung (31) zum Entfernen von Schmutz von dem Transportband (11,12) vorhanden ist.

11. Druckvorrichtung nach einem der vorhergehenden Ansprüche, **dadurch gekennzeichnet, dass** die Druckvorrichtung (1) zwei verschiebbare Drucknester (3,4) aufweist, denen jeweils eine Transportbandeinrichtung (15,14) zugeordnet ist, wobei die Drucknester (3,4) abwechselnd in die eine dem Druckkopf (2) zugeordnete Bearbeitungsposition verschiebbar sind.

12. Druckvorrichtung nach einem der vorhergehenden Ansprüche, **dadurch gekennzeichnet, dass** dem Drucknest (3,4) eine eigene Zuführ- und Abführeinrichtung (5,6) für die Substrate zugeordnet ist.

13. Druckvorrichtung nach Anspruch 12, **dadurch gekennzeichnet, dass** die jeweilige Zuführ- und Abführeinrichtung (5,6) ein Zuführförderband (29) und ein Abführförderband (30) aufweist, die übereinander liegen und in der Höhe verstellbar sind.

14. Druckvorrichtung nach Anspruch 13, **dadurch gekennzeichnet, dass** Zuführförderband (29) und Abführförderband (30) an einem gemeinsamen, in der Höhe verstellbaren Halter angeordnet sind.

15. Druckvorrichtung nach einem der vorhergehenden Ansprüche, **dadurch gekennzeichnet, dass** dem jeweiligen Drucknest (3,4) in seiner Substrataustauschposition zumindest ein Sensor, insbesondere Kamerasensor (26,27), eine Justiereinrichtung zum Erfassen und Korrigieren einer Position und/oder Ausrichtung zumindest eines auf dem Drucknest (3,4) befindlichen Substrats zugeordnet ist.

## Claims

1. Printing machine (1) for printing substrates such as circuit boards, wafers or solar cells, comprising at least one movably mounted printing unit (3,4) with a working surface (19) on which the substrate to be printed can be placed, wherein the printing unit (3,4) is paired with a transport belt device (15,14) which comprises a rotatably mounted supply roller (16) with a transport belt (11,12) wound thereon, and a rotatably mounted collection roller (17) for winding up the transport belt (11,12), as well as two deflecting surfaces, in particular deflecting rollers (18,20), paired with the working surface (19), wherein the transport belt (11,12) is guided by the supply roller (16) over one of the deflecting surfaces and onto the working surface (19) in order to form a contact surface for the substrates, and by the working surface (19) over the other deflecting surface to the collection roller (17), and comprising a print head (2), wherein the printing unit (3,4) is movable between a processing position paired with the print head (2) and a substrate exchange position paired with a feed- or removal device (5,6) for the substrates, wherein the deflecting surfaces (18,20) are movably held on the respective printing unit (3,4), **characterized in that** the supply roller (16) and the collection roller (17) are held on the printing machine (1) in a stationary manner.

2. Printing machine according to claim 1, **characterized in that** the supply roller (16) and the collection roller (17) are arranged below the printing unit (3,4).

3. Printing machine according to one of the preceding claims, **characterized in that** the printing unit (3,4) is at least substantially movable in a horizontal plane.

4. Printing machine according to one of the preceding claims, **characterized in that** the transport belt device (15,14) comprises at least one tensioning device (21), between the supply roller (16) and/or the collection roller (17) and at least one of the deflecting rollers (18,20), which acts on the transport belt (11,12) in order to keep it tensioned at least in the substrate exchange position.

5. Printing machine according to claim 4, **characterized in that** the tensioning device (21) comprises at least one tensioning roller (22,23) which is preloaded against the transport belt (11,12) between the collection roller (17) or the supply roller (16) and the at least one deflecting roller (18,20).

6. Printing machine according to one of the preceding claims, **characterized in that** the transport belt device (15,14) comprises at least one movably mounted deflecting roller (38,39) which interacts with the transport belt (11,12), and a controllable actuator (41) to move the movably mounted deflecting roller (38,39).

7. Printing machine according to claim 6, **characterized in that** the transport belt device (15,14) comprises two first guide tensioning rollers (34,35) between the supply roller (16) and one of the deflecting rollers (18) and/or two second guide tensioning rollers (36,37) between the deflecting roller (20) and the collection roller (17), wherein the movably mounted deflecting rollers (38,39) are particularly linearly movable between the first guide tensioning rollers (34,35) and/or the second guide tensioning rollers (36,37).

8. Printing machine according to one of the preceding claims, **characterized in that** the supply roller (16) and the collection roller (17) are each arranged vertically offset from the deflecting surfaces of the printing unit (3,4) in the processing position and in the substrate exchange position.

9. Printing machine according to one of the preceding claims, **characterized in that** the transport belt device (15,14) comprises a verification device (24) for contactless detection of transport belt contamination.

10. Printing machine according to one of the preceding claims, **characterized in that** a cleaning device (31) is provided for removing dirt from the transport belt (11,12).

11. Printing machine according to one of the preceding claims, **characterized in that** the printing machine (1) comprises two movable printing units (3,4), each of which is paired with a transport belt device (15,14), wherein the printing units (3,4) are alternately movable into the processing position paired with the print head (2).

12. Printing machine according to one of the preceding claims, **characterized in that** the printing unit (3,4) is paired with its own feed- and removal device (5,6) for the substrates.

13. Printing machine according to claim 12, **characterized in that** each of the feed- and removal devices (5,6) comprises a feed conveyor belt (29) and a removal conveyor belt (30), which lie one above the other and are adjustable in height.

14. Printing machine according to claim 13, **characterized in that** the feed conveyor belt (29) and the removal conveyor belt (30) are arranged on the same, height-adjustable holder.

15. Printing machine according to one of the preceding claims, **characterized in that** each of the printing units (3,4) in its substrate exchange position is paired with at least one sensor, in particular a camera sensor (26,27), an adjusting device used for detecting and correcting a position and/or orientation of at least one substrate situated on the printing unit (3,4).

## Revendications

1. Dispositif d'impression (1) pour l'impression de substrats, par exemple des cartes de circuits imprimés, des tranches de silicium ou des cellules solaires, comprenant au moins un nid d'impression (3, 4) monté de manière déplaçable et muni d'une surface de travail (19) sur laquelle les substrats peuvent être placés en vue de l'impression, dans lequel un dispositif de bande transporteuse (15, 14) est associé au nid d'impression (3, 4), ledit dispositif de bande transporteuse présentant un rouleau d'alimentation (16), monté rotatif et sur lequel est enroulée une bande transporteuse (11, 12), et un rouleau collecteur (17), monté rotatif et permettant d'enrouler la bande transporteuse (11, 12), ainsi que deux surfaces de renvoi, en particulier des rouleaux de renvoi (18, 20), associées à la surface de travail (19), dans lequel la bande transporteuse (11, 12) est guidée depuis le rouleau d'alimentation (16) jusque sur la surface de travail (19) en passant par l'une des surfaces de renvoi de manière à former une surface d'appui pour les substrats et depuis la surface de travail (19) jusqu'au rouleau collecteur (17) en passant par l'autre des surfaces de renvoi, et comprenant une tête d'impression (2), dans lequel le nid d'impression (3, 4) peut être déplacé entre une position de traitement associée à la tête d'impression (2) et une position d'échange de substrat associée à un dispositif d'amenée ou d'évacuation (5, 6) destiné aux substrats, dans lequel les surfaces de renvoi (18, 20) sont retenues sur le nid d'impression (3, 4) respectif de manière à pouvoir être déplacées conjointement, **caractérisé en ce que** aussi bien le rouleau d'alimentation (16) que le rouleau collecteur (17) sont retenus de manière fixe sur le dispositif d'impression (1).

2. Dispositif d'impression selon la revendication 1, **caractérisé en ce que** le rouleau d'alimentation (16) et le rouleau collecteur (17) sont agencés sous le nid d'impression (3, 4).

3. Dispositif d'impression selon l'une quelconque des revendications précédentes, **caractérisé en ce que** le nid d'impression (3, 4) peut être déplacé au moins essentiellement dans un plan horizontal.

4. Dispositif d'impression selon l'une quelconque des revendications précédentes, **caractérisé en ce que** le dispositif de bande transporteuse (15, 14) présente, entre le rouleau d'alimentation (16) et/ou le rouleau collecteur (17) et au moins un des rouleaux de renvoi (18, 20), au moins un dispositif de tension (21) qui agit sur la bande transporteuse (11, 12) pour maintenir celle-ci tendue au moins dans la position d'échange de substrat.

5. Dispositif d'impression selon la revendication 4, **caractérisé en ce que** le dispositif de tension (21) présente au moins un rouleau de tension (22, 23) qui est précontraint contre la bande transporteuse (11, 12) entre le rouleau collecteur (17) ou le rouleau d'alimentation (16) et le au moins un rouleau de renvoi (18, 20).

6. Dispositif d'impression selon l'une quelconque des revendications précédentes, **caractérisé en ce que** le dispositif de bande transporteuse (15, 14) présente au moins un rouleau de renvoi (38, 39), monté de manière déplaçable et coopérant avec la bande transporteuse (11, 12), et un actionneur (41) commandable permettant de déplacer le rouleau de renvoi (38, 39) monté de manière déplaçable.

7. Dispositif d'impression selon la revendication 6, **caractérisé en ce que** le dispositif de bande transporteuse (15, 14) présente deux premiers rouleaux de tension de renvoi (34, 35) entre le rouleau d'alimentation (16) et un des rouleaux de renvoi (18) et/ou deux deuxièmes rouleaux de tension de renvoi (36, 37) entre le rouleau de renvoi (20) et le rouleau collecteur (17), dans lequel les rouleaux de renvoi (38, 39) montés de manière déplaçable peuvent être déplacés en particulier de manière linéaire entre les premiers rouleaux de tension de renvoi (34, 35) et/ou les deuxièmes rouleaux de tension de renvoi (36, 37).

8. Dispositif d'impression selon l'une quelconque des revendications précédentes, **caractérisé en ce que** le rouleau d'alimentation (16) et le rouleau collecteur (17) sont respectivement agencés de manière décalée verticalement par rapport aux surfaces de renvoi du nid d'impression (3, 4) dans la position de traitement et dans la position d'échange de substrat.

9. Dispositif d'impression selon l'une quelconque des revendications précédentes, **caractérisé en ce que** le dispositif de bande transporteuse (15, 14) présente un dispositif de vérification (24) permettant de détecter sans contact une contamination de bande transporteuse.

10. Dispositif d'impression selon l'une quelconque des revendications précédentes, **caractérisé en ce qu'**un dispositif de nettoyage (31) permettant d'éliminer la saleté de la bande transporteuse (11, 12) est fourni.

11. Dispositif d'impression selon l'une quelconque des revendications précédentes, **caractérisé en ce que** le dispositif d'impression (1) présente deux nids d'impression (3, 4) déplaçables, auxquels est associé respectivement un dispositif de bande transporteuse (15, 14), dans lequel le nid d'impression (3, 4) peut être déplacé de manière alternée dans la position de traitement associées à la tête d'impression (2).

12. Dispositif d'impression selon l'une quelconque des revendications précédentes, **caractérisé en ce qu'**un dispositif d'amenée et d'évacuation (5, 6) individuel destiné aux substrats est associé au nid d'impression (3, 4).

13. Dispositif d'impression selon la revendication 12, **caractérisé en ce que** le dispositif d'amenée et d'évacuation (5, 6) respectif présente une bande transporteuse d'amenée (29) et une bande transporteuse d'évacuation (30) qui sont superposées et réglables en hauteur.

14. Dispositif d'impression selon la revendication 13, **caractérisé en ce que** la bande transporteuse d'amenée (29) et la bande transporteuse d'évacuation (30) sont agencées sur un support commun réglable en hauteur.

15. Dispositif d'impression selon l'une quelconque des revendications précédentes, **caractérisé en ce qu'au** nid d'impression (3, 4) respectif dans sa position d'échange de substrat est associé au moins un capteur, en particulier un capteur de caméra (26, 27), un dispositif d'ajustement permettant de détecter et corriger une position et/ou orientation d'au moins un substrat se trouvant sur le nid d'impression (3, 4).
